# EUROPEAN PATENT APPLICATION

(11) **EP 4 250 369 A2**
(43) Date of publication of application: **27.09.2023**
(21) Application number: 22206624.3
(22) Date of filing: 10.11.2022
(51) Int. Cl.: H01L 29/778, H01L 29/40, H01L 23/29, H01L 29/20

(54) **POWER DEVICE AND METHOD OF MANUFACTURING THE SAME**

(30) Priority: 24.03.2022 KR 20220036930
(71) Applicant: Samsung Electronics Co., Ltd., Gyeonggi-do 16677 (KR)
(72) Inventor: HWANG, Injun, 16678 Gyeonggi-do (KR)
(74) Representative: Grünecker Patent- und Rechtsanwälte PartG mbB

(57) **Abstract**

A power device and a method of manufacturing the power device is disclosed. The power device includes a channel layer (110), a source electrode (141) and a drain electrode (142) provided over the channel layer, a gate electrode (130) provided over the channel layer between the source electrode and the drain electrode, at least one first field plate (160) extending from above the gate electrode toward the drain electrode and including a metal, and a high-k dielectric layer (170) provided on at least one of a lower surface and a side surface of the at least one first field plate.

## Description

### BACKGROUND

### 1. Field

**The** present disclosure relates to a power device and a method of manufacturing the power device.

### 2. Description of the Related Art

Various power conversion systems may require devices that control currents through ON/OFF switching, that is, power devices. The efficiency of power devices may determine the efficiency of power conversion systems.

It may be difficult to increase the efficiency of power devices based on silicon (Si) due to limitations in physical properties of silicon and limitations in manufacturing processes. In order to overcome the limitations, research or development is being conducted to increase conversion efficiency by applying a III-V-based compound semiconductor, such as GaN, to power devices.

### SUMMARY

Example embodiments provide a power device and a method of manufacturing the power device.

The invention is claimed in the independent claims. Preferred embodiments are specified in the dependent claims.

Additional aspects will be set forth in part in the description which follows and, in part, will be apparent from the description, or may be learned by practice of the presented embodiments of the disclosure.

According to an embodiment, a power device may include a channel layer; a source electrode and a drain electrode on both sides of the channel layer, respectively; a gate electrode over the channel layer between the source electrode and the drain electrode; a first field plate above the gate electrode and extending in a direction from the gate electrode toward the drain electrode, the first field plate including a metal; and a high-k dielectric layer on a lower surface of the first field plate, a side surface of the first field plate, or both the lower surface of the first field plate and the side surface of the first field plate.

In some embodiments, the first field plate may contact the source electrode and may be integral with the source electrode.

In some embodiments, the first field plate may have a thickness of 10 nm to 10 µm.

In some embodiments, the high-k dielectric layer may have a thickness of 100 nm to 3 µm.

In some embodiments, the high-k dielectric layer may include at least one of SiON, SiN, Al₂O₃, HfO, and ZrO.

In some embodiments, the high-k dielectric layer may fill a space between the first field plate and the gate electrode.

In some embodiments, the power device may further include a low-k dielectric layer covering the first field plate and the high-k dielectric layer.

In some embodiments, the low-k dielectric layer may include SiO.

In some embodiments, the power device may further include a low-k dielectric layer in a space between the first field plate and the gate electrode.

In some embodiments, the low-k dielectric layer may have a thickness of 100 nm to 3 µm.

In some embodiments, a plurality of first field plates may be above the gate electrode. The first field plate may be one of the plurality of first field plates. Lengths of the plurality of first field plates may gradually increase in the direction from the gate electrode toward the drain electrode as a distance of the plurality of first plates increases from the channel layer.

In some embodiments, the plurality of first field plates may increase in thickness as a distance of the plurality of first field plates increase from the channel layer increases.

In some embodiments, a plurality of high-k dielectric layers may be on the plurality of first field plates. The high-k dielectric layer may be one of the plurality of high-k dielectric layers, and thicknesses of the plurality of high-k dielectric layers may increase as a distance of the plurality of high-k dielectric layers from the channel layer increases.

In some embodiments, a second field plate may be connected to the drain electrode and may extend in a direction from the drain electrode toward the gate electrode.

In some embodiments, the channel layer may include a GaN-based material.

In some embodiments, a barrier layer may be on the channel layer. The barrier layer may be configured to induce a 2-dimensional electron gas (2DEG) in the channel layer.

In some embodiments, the barrier layer may include a nitride including at least one of Al, Ga, In, and B.

In some embodiments, the gate electrode may include at least one of Ni, Pt, Pd, and Au.

In some embodiments, the power device may further include an insulating layer between the channel layer and the gate electrode.

In some embodiments, the insulating layer may include at least one of SiO, SiN, SiON, AIO, and AION.

In some embodiments, the gate electrode may include at least one of Ti, Al, Ni, Pt, Pd, and Au.

In some embodiments, the power device may further include a depletion forming layer between the channel layer and the gate electrode.

In some embodiments, the depletion forming layer may include a p-type III-V-based nitride semiconductor.

In some embodiments, the gate electrode may include at least one of Ti, Al, Ni, Pt, Pd, and Au.

According to an embodiment, a method of manufacturing a power device may include forming a gate electrode on a channel layer; forming a low-k dielectric layer on the channel layer, the low-k dielectric layer covering the gate electrode; forming a first high-k dielectric layer on an upper surface of the low-k dielectric layer; forming a metal layer on a side surface of the first high-k dielectric layer, a side surface of the low-k dielectric layer, and an upper surface of the first high-k dielectric layer; and forming a source electrode on a side of the channel layer. The forming the source electrode may include etching a portion of the metal layer and a portion of the first high-k dielectric layer, and at a same time forming a field plate on the upper surface of the first high-k dielectric layer.

In some embodiments, the low-k dielectric layer may include SiO.

In some embodiments, the first high-k dielectric layer may include at least one of SiON, SiN, Al₂O₃, HfO, and ZrO.

In some embodiments, in the forming the source electrode, the metal layer and the first high-k dielectric layer may be etched by a single photo process.

In some embodiments, in the forming the source electrode, the field plate may be formed above the gate electrode and may be formed to extend in a direction from the gate electrode toward a drain electrode, and the first high-k dielectric layer may be formed on a lower surface of the field plate.

In some embodiments, the method may further include forming a second high-k dielectric layer covering the field plate and the low-k dielectric layer and etching the second high-k dielectric layer such that the second high-k dielectric layer remains only on a side surface of the field plate.

In some embodiments, the second high-k dielectric layer may be formed by isotropic deposition, and the etching the second high-k dielectric layer may be performed by anisotropic etching.

According to an embodiment, a method of manufacturing a power device may include forming a gate electrode on a channel layer; forming a low-k dielectric layer on the channel layer, the low-k dielectric layer covering the gate electrode; forming a metal layer on a side surface of the low-k dielectric layer and an upper surface of the low-k dielectric layer; forming a source electrode on a side of the channel layer, the forming the source electrode including etching a portion of the metal layer and at a same time forming a field plate on the upper surface of the low-k dielectric layer; forming a high-k dielectric layer covering the field plate and the low-k dielectric layer; and etching the high-k dielectric layer such that the high-k dielectric layer remains only on a side surface of the field plate.

According to an embodiment, a method of manufacturing a power device may include forming a gate electrode on a channel layer; forming a high-k dielectric layer on the channel layer, the high-k dielectric layer covering the gate electrode; forming a metal layer on a side surface of the high-k dielectric layer and an upper surface of the high-k dielectric layer; forming a source electrode on a side of the channel layer, the forming the source electrode including etching a portion of the metal layer and a portion the high-k dielectric layer, and at a same time forming a field plate on the upper surface of the high-k dielectric layer; and forming a low-k dielectric layer covering the field plate and the high-k dielectric layer.

According to an embodiment, a power device may include a channel layer; a source electrode, a gate electrode, and a drain electrode spaced apart from each other in a first direction on the channel layer, the gate electrode between the source electrode and the drain electrode; a first metal structure on the source electrode and spaced apart from the gate electrode; and a high-k dielectric layer. The first metal structure may include a first field plate. The first field plate may extend in the first direction over the gate electrode such that a lower surface of the first field plate faces the gate electrode. A side surface of the first field plate may be over a region of the channel layer between the gate electrode and the drain electrode. The high-k dielectric layer may be on the lower surface of the first field plate, the side surface of the first field plate, or both the lower surface of the first field plate and the side surface of the first field plate.

In some embodiments, the first metal structure may include a vertical portion. The vertical portion may extend from a top surface of the source electrode in a direction perpendicular to the top surface of the source electrode. The first field plate may extend in the first direction from a sidewall of the vertical portion.

In some embodiments, the first metal structure may include a plurality of first field plates spaced apart from each other in the vertical direction along the vertical portion of the first metal structure. The plurality of first field plates may include the first field plate. The plurality of first field plates may extend different lengths in the first direction.

In some embodiments, a plurality high-k dielectric layers may be on lower surfaces of the plurality of first field plates, side surfaces of the plurality of first field plates, or both the lower surfaces of the plurality of first field plates and the side surfaces of the plurality of first field plates.

In some embodiments, a second metal structure may be on the drain electrode. The second metal structure may be spaced apart from the gate electrode and the first metal structure. The second metal structure may include a second field plate. The second field plate may extend toward to the first metal structure in a direction opposite the first direction.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a cross-sectional view illustrating a power device according to an example embodiment;
FIG. 2 is a cross-sectional view illustrating a power device according to another example embodiment;
FIG. 3 is a cross-sectional view illustrating a power device according to another example embodiment;
FIGS. 4A to 4D are views illustrating a method of manufacturing a power device, according to an example embodiment;
FIG. 5 is a cross-sectional view illustrating a power device according to another example embodiment;
FIGS. 6A to 6C are views illustrating a method of manufacturing a power device, according to another example embodiment;
FIG. 7 is a cross-sectional view illustrating a power device according to another example embodiment;
FIGS. 8A to 8E are views illustrating a method of manufacturing a power device, according to another example embodiment;
FIG. 9 is a cross-sectional view illustrating a power device according to another example embodiment;
FIGS. 10A to 10D are views illustrating a method of manufacturing a power device, according to another example embodiment;
FIG. 11 is a cross-sectional view illustrating a power device according to another example embodiment;
FIG. 12 is a cross-sectional view illustrating a power device according to another example embodiment;
FIG. 13 is a cross-sectional view illustrating a power device according to another example embodiment;
FIG. 14 illustrates a block diagram of an electronic system including a power device according to an example embodiment; and
FIG. 15 is a block diagram of an electronic device including a power device according to an example embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C") may be construed as A only, B only, C only, or any combination of two or more of A, B, and C, such as, for instance, ABC, AB, BC, and AC.

Hereinafter, example embodiments will be described in detail with reference to the accompanying drawings. In the following drawings, the same reference numerals refer to the same components, and a size of each component in the drawings may be exaggerated for the sake of clear and convenient description. In addition, the following embodiments to be described are merely examples, and various modifications may be made from the embodiments.

Hereinafter, what is described as "upper portion" or "on or upper" may also include not only components directly thereon, thereunder, on the left, and on the right in contact therewith but also components thereon, thereunder, on the left, and on the right without being in contact therewith. Singular expressions include plural expressions unless the context clearly indicates otherwise. In addition, when a portion "includes" a certain component, this means that other components may be further included rather than excluding other components unless specifically stated to the contrary.

Use of a term "the" and similar reference terms may correspond to both the singular and the plural. Steps constituting a method may be performed in any suitable order unless there is a clear statement that the steps should be performed in the order described or contrary to the order and are not limited thereto.

In addition, terms such as "... unit", "... portion", and "module" described in the specification mean units that process at least one function or operation, which may be implemented as hardware or software, or as a combination of hardware and software.

Connection or connection members of lines between configuration elements illustrated in the drawings exemplarily represent functional connections and/or physical or circuit connections and may be represented as alternative or additional various functional connections, physical connections, or circuit connections in an actual apparatus.

Use of all examples or all example terms is merely for describing technical ideas in detail, and the scope of claims is not limited by the examples or the example terms unless limited by the claims.

**The** following example embodiments describe, for example, a high electron mobility transistor (HEMT) as a power device but is not limited thereto.

**The** HEMT includes semiconductor layers with different electrical polarization characteristics. In the HEMT, a semiconductor layer with a relatively large polarizability may induce 2-dimensional electron gas (2DEG) in another semiconductor layer bonded thereto, and the 2DEG may have very high electron mobility.

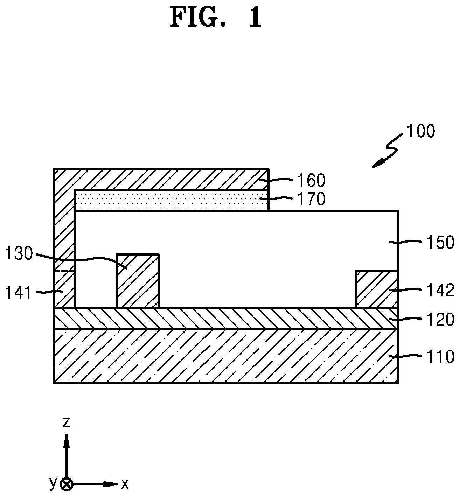

FIG. 1 is a cross-sectional view illustrating a power device 100 according to an example embodiment.

Referring to FIG. 1, a barrier layer 120 is provided on a channel layer 110. The channel layer 110 and the barrier layer 120 may include semiconductor materials with different electrical polarization characteristics. The channel layer 110 may be provided on a substrate (not illustrated). The substrate may include, for example, sapphire, Si, SiC, or GaN, but is not limited thereto and may include various other materials.

**The** channel layer 110 may include a first semiconductor material. Here, the first semiconductor material may include a III-V-based compound semiconductor material but is not limited thereto. For example, the channel layer 110 may include a GaN-based material layer, for example, a GaN layer. In this case, the channel layer 110 may include an undoped GaN layer, or in some cases, a GaN layer doped with a certain impurity.

A buffer layer (not illustrated) may be further provided between the channel layer 110 and a substrate. The buffer layer is provided to reduce differences in lattice constants and thermal expansion coefficients between the substrate and the channel layer 110. The buffer layer may include a nitride including at least one of Al, Ga, In, and B and may have a single-layer structure or multi-layer structure. For example, the buffer layer may include at least one of AIN, GaN, AIGaN, InGaN, AlInN, and AlGaInN. A seed layer (not illustrated) for growth of the buffer layer may also be further provided between the substrate and the buffer layer.

The barrier layer 120 may be provided on the channel layer 110. The barrier layer 120 may induce a 2DEG in the channel layer 110. Here, the 2DEG may be induced in the channel layer 110 beneath an interface between the channel layer 110 and the barrier layer 120. The barrier layer 120 may include a second semiconductor material that is different from the first semiconductor material forming the channel layer 110. The second semiconductor material may be different from the first semiconductor material in at least one of polarization characteristics, an energy bandgap, and a lattice constant.

The second semiconductor material may be greater than the first semiconductor material in at least one of polarizability and an energy bandgap. The barrier layer 120 may include a nitride including at least one of, for example, Al, Ga, In, and B. In a specific example, the barrier layer 120 may include at least one of AIGaN, AlInN, InGaN, AIN, and AlInGaN. However, the present disclosure is not limited thereto. The barrier layer 120 may include an undoped layer, but it may also include a layer doped with a certain impurity. The barrier layer may have a single-layer structure or a multi-layer structure.

A source electrode 141 and a drain electrode 142 may be provided on both sides of the barrier layer 120. The source electrode 141 and the drain electrode 142 may be provided to extend in a y-axis direction in parallel with each other. The source electrode 141 and the drain electrode 142 may include, for example, a metal material, such as Al or Ti. FIG. 1 illustrates as an example a case in which the source electrode 141 and the drain electrode 142 are in contact with the upper surface of the barrier layer 120. However, the present disclosure is not limited thereto, and the source electrode 141 and the drain electrode 142 may have a desired and/or alternatively preset depth from the upper surface of the barrier layer 120 or may also be in contact with the channel layer 110.

A gate electrode 130 may be provided on the barrier layer 120 between the source electrode 141 and the drain electrode 142. The gate electrode 130 may extend in the y-axis direction in parallel with the source electrode 141 and the drain electrode 142. The gate electrode 130 may include a conductive material, such as a metal material or a metal compound. For example, the gate electrode 130 may include at least one of Ni, Pt, Pd, and Au. However, the present disclosure is not limited thereto. The gate electrode 130 may have a thickness of, for example, about 100 nm to about 300 nm, but this is merely an example.

A field plate 160 is provided above the gate electrode 130. The field plate 160 may extend from above the gate electrode 130 toward the drain electrode 142 (that is, in the x-axis direction). The field plate 160 may be connected to the source electrode 141. The field plate 160 may be formed integrally with the source electrode 141. The field plate 160 may include a metal material, such as Al or Ti.

In an OFF state of an HEMT, the 2DEG is depleted to apply a high electric field to an edge portion of a gate electrode, and thus, a breakdown voltage may reduce or a leakage current may increase. In the present embodiment, by providing the field plate 160 above the gate electrode 130, an electric field applied to an edge portion of the gate electrode 130 may disperse, and accordingly, a breakdown voltage may increase and a leakage current may reduce.

The field plate 160 may have a thickness of, for example, about 10 nm to about 10 µm. For example, when the field plate 160 is formed of metal only for the purpose of dispersion of an electric field only, the field plate 160 may have a thickness of about 10 nm to about 100 nm. For example, when the field plate 160 is formed of a metal for wiring of an integrated circuit (IC), the field plate 160 may have a thickness of about 100 nm to about 1 µm. For example, when the field plate 160 is formed of a metal for power wiring for reducing source and drain resistance, the field plate 160 may have a thickness of about 3 µm to about 10 µm. However, this is merely an example.

A high-k dielectric layer 170 may be provided on the lower surface of the field plate 160. The high-k dielectric layer 170 may include a dielectric material with a dielectric constant that is greater than a dielectric constant of silicon oxide. For example, the high-k dielectric layer 170 may include at least one of SiON, SiN, Al₂O₃, HfO, and ZrO. However, the present disclosure is not limited thereto.

The high-k dielectric layer 170 provided on the lower surface of the field plate 160 may disperse more effectively an electric field applied to an edge portion of the gate electrode 130, thereby further increasing a breakdown voltage thereof. The high-k dielectric layer 170 may have a thickness of, for example, about 100 nm to about 3 µm. However, the present disclosure is not limited thereto.

A low-k dielectric layer 150 may be provided between the high-k dielectric layer 170 and the barrier layer 120. The low-k dielectric layer 150 may be provided on the barrier layer 120 to cover the gate electrode 130 and the drain electrode 142.

**The** low-k dielectric layer 150 may include a material with a dielectric constant that is less than a dielectric constant of the high-k dielectric layer 170. For example, the low-k dielectric layer 150 may include SiO. However, this is merely an example. The low-k dielectric layer 150 may have a thickness of, for example, about 100 nm to about 3 µm but is not limited thereto.

In the power device 100 according to the present embodiment, the field plate 160 extending toward the drain electrode 142 is provided above the gate electrode 130, and thus, an electric field applied to an edge portion of the gate electrode 130 may disperse. In addition, by providing the high-k dielectric layer 170 on the lower surface of the field plate 160, the electric field applied to the edge portion of the gate electrode 130 may be dispersed more effectively. Accordingly, a breakdown voltage may increase and a leakage current may reduce, and thus, the power device 100 with improved high voltage characteristics and reliability may be implemented.

Although a metal-semiconductor (MES) gate structure in which the gate electrode 130 is directly provided on the barrier layer 120 is described above, an insulating layer may be provided between the barrier layer 120 and the gate electrode 130, or a depletion forming layer may be provided between the barrier layer 120 and the gate electrode 130 as described below.

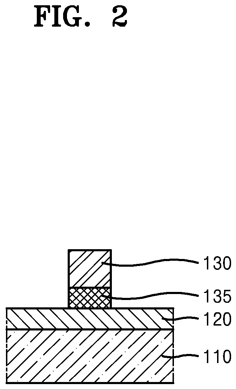

FIG. 2 illustrates a metal-insulator-semiconductor (MIS) gate structure in which an insulating layer 135 is provided between the barrier layer 120 and the gate electrode 130. The insulating layer 135 may include at least one of, for example, SiO, SiN, SiON, AIO, and AION. The gate electrode 130 may include at least one of, for example, Ti, Al, Ni, Pt, Pd, and Au. However, this is merely an example. The gate electrode 130 may have a thickness of, for example, about 100 nm about to 300 nm, and the insulating layer 135 may have a thickness of, for example, about 5 nm to about 100 nm. However, the present disclosure is not limited thereto.

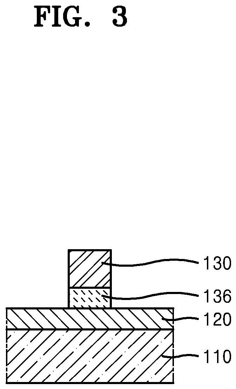

FIG. 3 illustrates a gate structure in which a depletion forming layer 136 is formed between the barrier layer 120 and the gate electrode 130. The depletion forming layer 136 may include a p-type semiconductor material. That is, the depletion forming layer 136 may include a semiconductor layer doped with a p-type impurity. The depletion forming layer 136 may include a III-V-based nitride semiconductor. The depletion forming layer 136 may include a material in which at least one of, for example, GaN, AIGaN, InN, AlInN, InGaN, and AlInGaN is doped with a p-type impurity. In a specific example, the depletion forming layer 136 may include a p-GaN layer.

**The** gate electrode 130 may include at least one of, for example, Ti, Al, Ni, Pt, Pd, and Au. However, this is merely an example. The gate electrode 130 may have a thickness of, for example, about 100 nm to about 300 nm, and the depletion forming layer 136 may have a thickness of, for example, about 50 nm to about 100 nm. However, the present disclosure is not limited thereto.

The depletion forming layer 136 may increase an energy bandgap of a portion of the barrier layer 120 thereunder, and thus, a depletion region of 2DEG may be formed in a portion of the channel layer 110 corresponding to the depletion forming layer 136. Due to the depletion region, a power device may have normally-off characteristics in which there is no current flowing between the drain electrode 142 and the source electrode 141 when the gate voltage is 0 V.

In general, when an HEMT is in a normally-on state in which, when a gate voltage is 0 V, a current flows due to low resistance between a drain electrode and a source electrode, current and power may be consumed. In order to limit and/or prevent a current from flowing between the drain electrode and the source electrode in a normally-on HEMT, a negative voltage has to be applied to the gate electrode. However, the depletion forming layer 136 may be provided between the barrier layer 120 and the gate electrode 130 to provide a HEMT with normally-off characteristics, where there is no current flowing between the drain electrode 142 and the source electrode 141 when the gate voltage is 0 V.

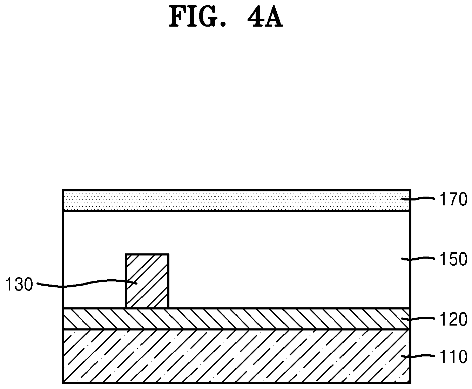

FIGS. 4A to 4D are views illustrating a method of manufacturing the power device 100 illustrated in FIG. 1.

Referring to FIG. 4A, the barrier layer 120 is formed on the channel layer 110. The channel layer 110 may be formed on a substrate (not illustrated), and a buffer layer (not illustrated) may be further formed between the substrate and the channel layer 110. The channel layer 110 may include a first semiconductor material. Here, the first semiconductor material may include a III-V-based compound semiconductor material but is not limited thereto. For example, the channel layer 110 may include a GaN-based material layer, for example, a GaN layer. In this case, the channel layer 110 may include an undoped GaN layer, or in some cases, a GaN layer doped with a desired and/or alternatively preset impurity. The barrier layer 120 may include a second semiconductor material that is different from the first semiconductor material forming the channel layer 110. The barrier layer 120 may include a nitride including at least one of, for example, Al, Ga, In, and B. In a specific example, the barrier layer 120 may include at least one of AIGaN, AlInN, InGaN, AIN, and AlInGaN. However, the present disclosure is not limited thereto. The barrier layer 120 may include an undoped layer but may also include a layer doped with a desired and/or alternatively preset impurity.

**The** gate electrode 130 may be formed on the barrier layer 120. The gate electrode 130 may include at least one of, for example, Ni, Pt, Pd, and Au. The gate electrode 130 may have a thickness of, for example, about 100 nm to about 300 nm. However, the present disclosure is not limited thereto. In addition, the insulating layer 135 may be further formed between the barrier layer 120 and the gate electrode 130, as illustrated in FIG. 2, and the depletion forming layer 136 may be further formed between the barrier layer 120 and the gate electrode 130, as illustrated in FIG. 3.

The low-k dielectric layer 150 may be formed on the barrier layer 120 to cover the gate electrode 130. The low-k dielectric layer 150 may include a dielectric material with a dielectric constant that is less than a dielectric constant of the high-k dielectric layer 170, as described below. The low-k dielectric layer 150 may include, for example, SiO but is not limited thereto. The low-k dielectric layer 150 may be formed to have a thickness of, for example, about 100 nm to about 3 µm.

The high-k dielectric layer 170 may be formed on the low-k dielectric layer 150. The high-k dielectric layer 170 may include a dielectric material with a dielectric constant that is greater than a dielectric constant of a silicon oxide. For example, the high-k dielectric layer 170 may include at least one of SiON, SiN, Al₂O₃, HfO, and ZrO but is not limited thereto. The high-k dielectric layer 170 may be formed to have a thickness of, for example, about 100 nm to about 3 µm.

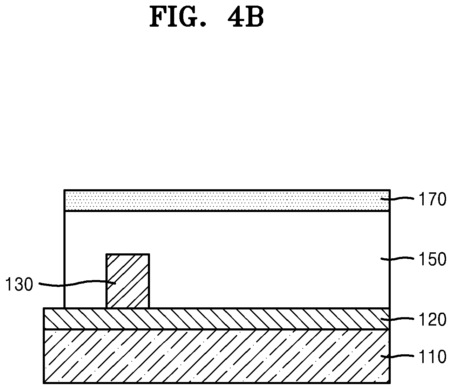

Referring to FIG. 4B, one side of the high-k dielectric layer 170 and one side of the low-k dielectric layer 150 may be removed by etching. Accordingly, the upper surface of the barrier layer 120 may be exposed through the etched portion.

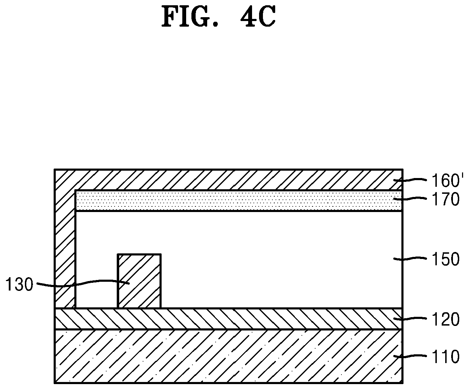

Referring to FIG. 4C, a metal layer 160' may be deposited on the structure illustrated in FIG. 4B. The metal layer 160' may cover one side of the low-k dielectric layer 150 and an upper surface of the high-k dielectric layer 170. The metal layer 160' may include a metal material forming an ohmic contact with the exposed upper surface of the barrier layer 120. For example, the metal layer 160' may include a metal material, such as Al or Ti but is not limited thereto. The metal layer 160' may have a thickness of, for example, about 10 nm to about 10 µm.

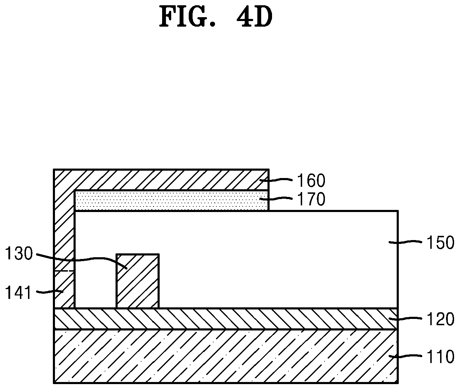

Referring to FIG. 4D, a part of the metal layer 160' and a part of the high-k dielectric layer 170 may be removed by etching so that the low-k dielectric layer 150 is exposed. Here, the metal layer 160' and the high-k dielectric layer 170 may be etched by a single photo/etch process. For example, a photoresist may be formed on the upper surface of the metal layer 160' and a photomask (not illustrated) may be provided thereon. Then, the photoresist may be patterned by a photolithography process. Next, the metal layer 160' and the high-k dielectric layer 170 may be sequentially etched by using the patterned photoresist as an etching mask.

Accordingly, the source electrode 141 forming an ohmic contact with the barrier layer 120 may be formed on one side of the low-k dielectric layer 150, and the field plate 160 may be formed on the upper surface of the high-k dielectric layer 170. That is, the high-k dielectric layer 170 may be formed on the lower surface of the field plate 160. In addition, although not illustrated in FIGS. 4A to 4D, a drain electrode (see drain electrode 142 in FIG. 1) may be formed simultaneously with a gate electrode or may be formed simultaneously with a source electrode. Alternatively, the drain electrode may be formed in a separate process from forming the gate electrode and/or the source electrode.

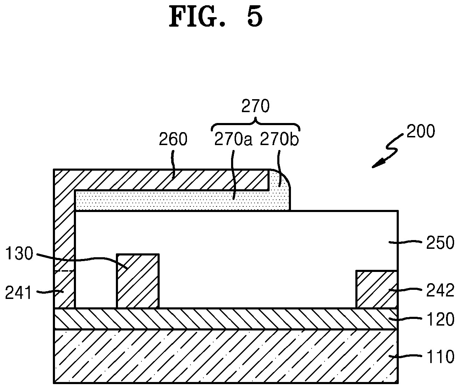

FIG. 5 is a cross-sectional view illustrating a power device according to another example embodiment. Hereinafter, differences from the power device 100 illustrated in FIG. 1 will be mainly described.

Referring to FIG. 5, the barrier layer 120 may be provided on the channel layer 110, and the gate electrode 130 may be provided on the barrier layer 120. In addition, a source electrode 241 and a drain electrode 242 may be provided on both sides of the barrier layer 120. A field plate 260 may be provided above the gate electrode 130, and the field plate 260 may extend from above the gate electrode 130 toward the drain electrode 242. Here, the field plate 260 may be provided integrally with the source electrode 241.

A high-k dielectric layer 270 may be provided in the field plate 260. The high-k dielectric layer 270 may include a first high-k dielectric layer 270a provided on the lower surface of the field plate 260 and a second high-k dielectric layer 270b provided on a side surface of the field plate 260. The high-k dielectric layer 270 may include at least one of, for example, SiON, SiN, Al₂O₃, HfO, and ZrO. A low-k dielectric layer 250 may be provided between the high-k dielectric layer 270 and the barrier layer 120. The low-k dielectric layer 250 may be provided on the barrier layer 120 to cover the gate electrode 130 and the drain electrode 242. The low-k dielectric layer 250 may include, for example, SiO, but this is merely an example.

In the present embodiment, the high-k dielectric layer 270 may be provided not only on the lower surface of the field plate 260 but also on the side surface of the field plate 260, and thus, an electric field applied to an edge portion of the gate electrode 130 may more effectively disperse.

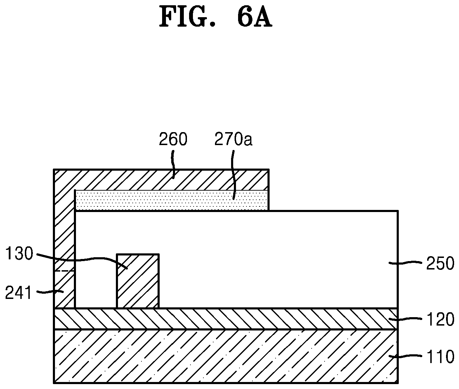

FIGS. 6A to 6C are views illustrating a method of manufacturing the power device 200 illustrated in FIG. 5.

**The** present embodiment performs the processes illustrated in FIGS. 4A to 4D, which are described above, and thus, descriptions thereof will be omitted. FIG. 6A illustrates the same structure as the structure illustrated in FIG. 4D.

Referring to FIG. 6A, the source electrode 241 forming an ohmic contact with the barrier layer 120 may be provided on one side of the low-k dielectric layer 250, and the field plate 260 and the source electrode 241 may be integrally formed with respect to the gate electrode 130. In addition, the first high-k dielectric layer 270a may be formed on the lower surface of the field plate 260.

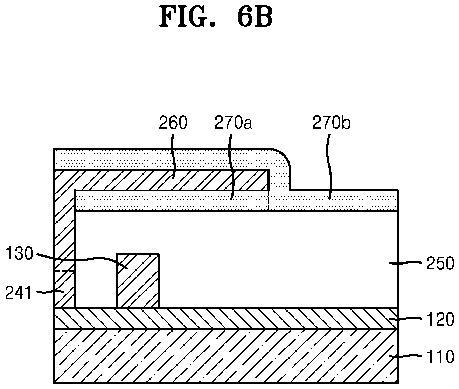

Referring to FIG. 6B, the second high-k dielectric layer 270b may be deposited to cover the field plate 260, the first high-k dielectric layer 270a, and the low-k dielectric layer 250. Here, the deposition of the second high-k dielectric layer 270b may be performed by isotropic deposition, and thus, the second high-k dielectric layer 270b may be formed to have a uniform thickness.

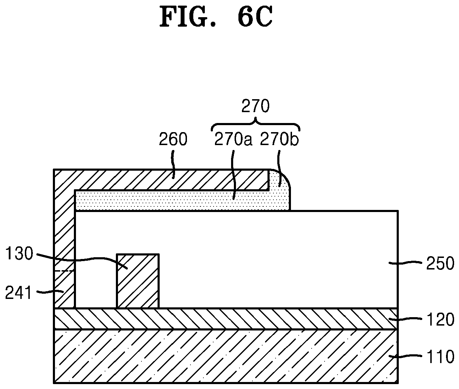

Referring to FIG. 6C, the second high-k dielectric layer 270b is etched such that only the second high-k dielectric layer 270b remains on a side surface of the field plate 260. Here, the etching of the second high-k dielectric layer 270b may be performed by anisotropic etching. Accordingly, the high-k dielectric layer 270 may be formed on the field plate 260. The high-k dielectric layer 270 may include the first high-k dielectric layer 270a formed on the lower surface of the field plate 260 and the second high-k dielectric layer 270b formed on a side surface of the field plate 260. In addition, although not illustrated in FIGS. 6A to 6C, a drain electrode (see drain electrode 242 in FIG. 5) may be formed simultaneously with a gate electrode 130 or may be formed simultaneously with the source electrode 241. Alternatively, the drain electrode may be formed in a separate process from forming the gate electrode and/or the source electrode.

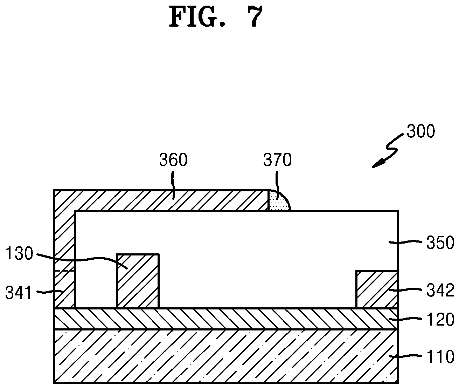

FIG. 7 is a cross-sectional view illustrating a power device 300 according to another example embodiment. Hereinafter, differences from the embodiments described above will be mainly described.

Referring to FIG. 7, the barrier layer 120 may be provided on the channel layer 110, and the gate electrode 130 may be provided on the barrier layer 120. In addition, a source electrode 341 and a drain electrode 342 may be provided on both sides of the barrier layer 120. A field plate 360 may be provided above the gate electrode 130, and the field plate 360 may extend from above the gate electrode 130 toward the drain electrode 342. Here, the field plate 360 may be provided integrally with the source electrode 341.

A high-k dielectric layer 370 may be provided on a side surface of the field plate 360. A low-k dielectric layer 350 may be provided between the field plate 360 and the barrier layer 120. The low-k dielectric layer 350 may be provided over the barrier layer 120 to cover the gate electrode 130 and the drain electrode 342. In the present embodiment, the high-k dielectric layer 370 may be provided on a side surface of the field plate 360, and thus, an electric field applied to an edge portion of the gate electrode 130 may effectively disperse.

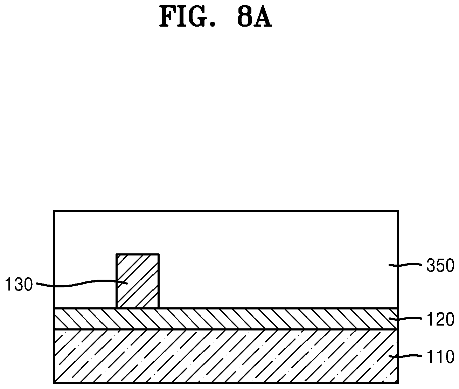

FIGS. 8A to 8E are views illustrating a method of manufacturing the power device 300 illustrated in FIG. 7.

Referring to FIG. 8A, the barrier layer 120 may be formed on the channel layer 110, and then, the gate electrode 130 may be formed on the barrier layer 120. Next, the low-k dielectric layer 350 may be formed on the barrier layer 120 to cover the gate electrode 130.

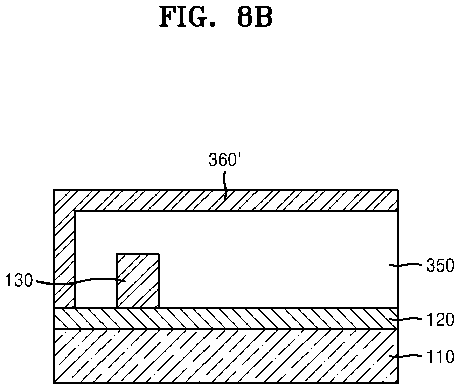

Referring to FIG. 8B, a part of the low-k dielectric layer 350 may be removed by etching. The upper surface of the barrier layer 120 may be exposed through the etched portion. Next, a metal layer 360' may be deposited on a side surface and the upper surface of the low-k dielectric layer 350. The metal layer 360' may include a metal material forming an ohmic contact with the exposed upper surface of the barrier layer 120.

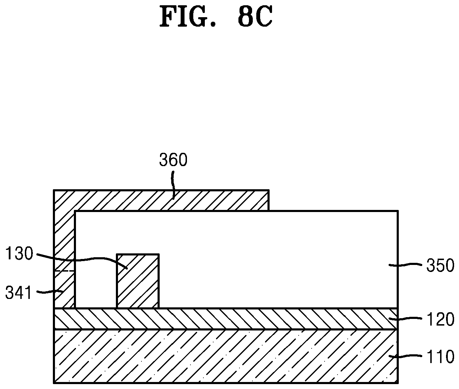

Referring to FIG. 8C, a part of the metal layer 360' may be etched so that the low-k dielectric layer 350 is exposed. Accordingly, the source electrode 341 forming an ohmic contact with the barrier layer 120 may be formed on one side of the low-k dielectric layer 350, and the field plate 360 may be formed on the upper surface of the low-k dielectric layer 350.

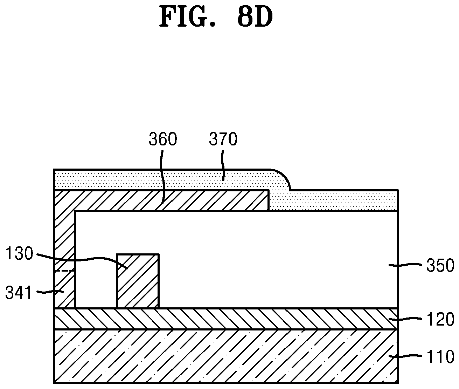

Referring to FIG. 8D, the high-k dielectric layer 370 may be deposited to cover the field plate 360 and the low-k dielectric layer 350. Here, the deposition of the high-k dielectric layer 370 may be performed by isotropic deposition, and thus, the high-k dielectric layer 370 may be formed to have a uniform thickness.

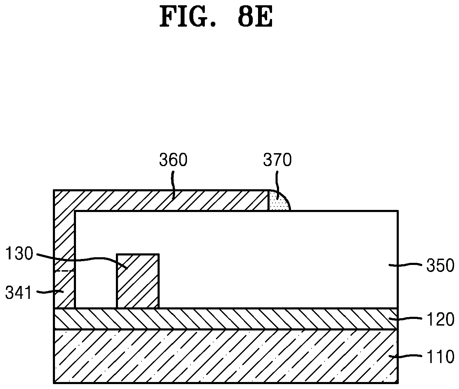

Referring to FIG. 8E, the high-k dielectric layer 370 may be etched such that only the high-k dielectric layer 370 remains on a side surface of the field plate 360. Here, the etching of the high-k dielectric layer 370 may be performed by anisotropic etching. In addition, although not illustrated in FIGS. 8A to 8E, a drain electrode (see drain electrode 342 in FIG. 7) may be formed simultaneously with a gate electrode 130 or may be formed simultaneously with the source electrode 341. Alternatively, the drain electrode may be formed in a separate process from forming the gate electrode and/or the source electrode.

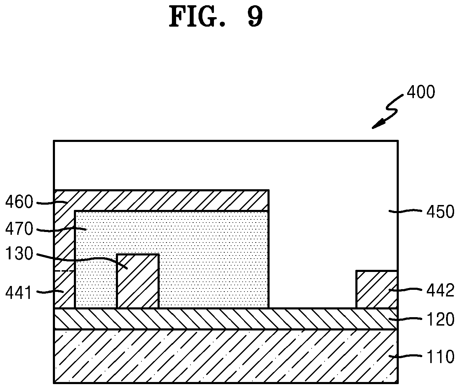

FIG. 9 is a cross-sectional view illustrating a power device 400 according to another example embodiment. Hereinafter, differences from the embodiments described above will be mainly described.

Referring to FIG. 9, the barrier layer 120 may be provided on the channel layer 110, and the gate electrode 130 may be provided on the barrier layer 120. In addition, a source electrode 441 and a drain electrode 442 may be provided on both sides of the barrier layer 120. A field plate 460 may be provided above the gate electrode 130, and the field plate 460 may extend from above the gate electrode 130 toward the drain electrode 442. Here, the field plate 460 may be provided integrally with the source electrode 441.

A high-k dielectric layer 470 may be provided on the lower surface of the field plate 460 to cover the gate electrode 130. The high-k dielectric layer 470 may fill a space between the field plate 460 and the gate electrode 130. A low-k dielectric layer 450 may be provided on the field plate 460. Specifically, the low-k dielectric layer 450 may be provided on the barrier layer 120 to cover the field plate 460, the high-k dielectric layer 470, and the drain electrode 442.

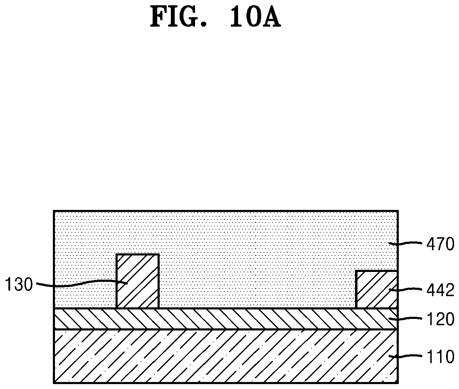

FIGS. 10A to 10D are views illustrating a method of manufacturing the power device 400 illustrated in FIG. 9.

Referring to FIG. 10A, the barrier layer 120 may be formed on the channel layer 110, and then, the gate electrode 130 may be formed on the barrier layer 120. Next, the high-k dielectric layer 470 may be formed on the barrier layer 120 to cover the gate electrode 130.

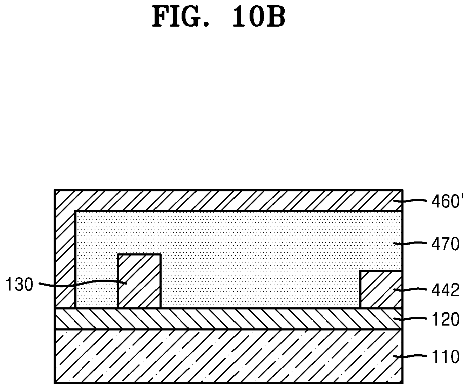

Referring to FIG. 10B, a part of the high-k dielectric layer 470 may be removed by etching. The upper surface of the barrier layer 120 may be exposed through the etched portion. Next, a metal layer 460' may be deposited on a side surface and the upper surface of the high-k dielectric layer 470. The metal layer 460' may include a metal material forming an ohmic contact with the exposed upper surface of the barrier layer 120.

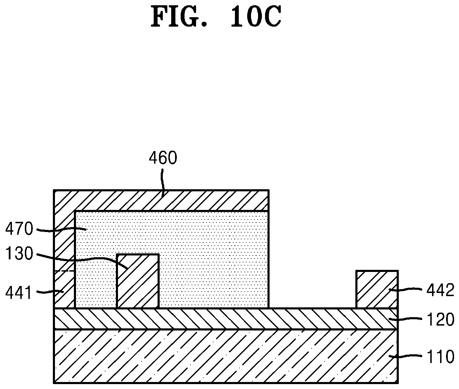

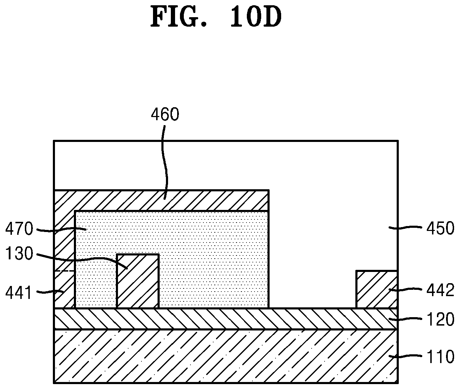

Referring to FIG. 10C, a part of the metal layer 460' and a part of the high-k dielectric layer 470 may be etched so that the barrier layer 120 is exposed. Here, the metal layer 460' and the high-k dielectric layer 470 may be etched by a single photo process. Accordingly, the source electrode 441 forming an ohmic contact with the barrier layer 120 may be formed on one side of the high-k dielectric layer 470, and the field plate 460 may be formed on the upper surface of the high-k dielectric layer 470. That is, the high-k dielectric layer 470 may be formed on the lower surface of the field plate 460. Referring to FIG. 10D, the barrier layer 120 may be formed to cover the field plate 460, the high-k dielectric layer 470, and the drain electrode 442.

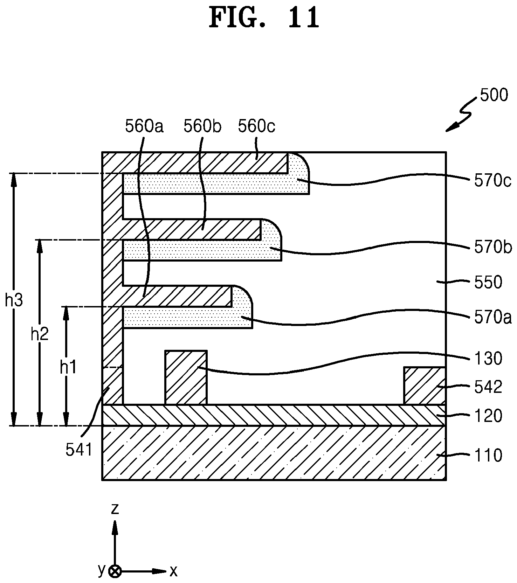

FIG. 11 is a cross-sectional view illustrating a power device 500 according to another example embodiment. Hereinafter, differences from the above-described embodiments will be mainly described.

Referring to FIG. 11, the barrier layer 120 may be provided on the channel layer 110, and the gate electrode 130 may be provided on the barrier layer 120. In addition, a source electrode 541 and a drain electrode 542 may be provided on both sides of the barrier layer 120.

First to third field plates 560a, 560b, and 560c may be provided above the gate electrode 130. Here, the first to third field plates 560a, 560b, and 560c may be provided integrally with the source electrode 541. Specifically, the first to third field plates 560a, 560b, and 560c may be sequentially provided above the gate electrode 130 to be separated from each other in the z-axis direction. The first to third field plates 560a, 560b, and 560c may extend toward the drain electrode 542 in the x-axis direction.

In order to more effectively disperse an electric field applied to an edge portion of the gate electrode 130, the first to third field plates 560a, 560b, and 560c may be disposed to increase in length as a distance from the channel layer 130 in a vertical direction (z-axis direction) increases. For example, as shown in FIG. 11, the first to third field plates 560a, 560b, and 560c may be arranged farther from the gate electrode 130 in the vertical direction, respectively, and may increase in a length toward the drain electrode 542 (in the x-axis direction), respectively. For example, the first field plate 560a having the shortest length toward the drain electrode 542 may have a distance h1 from the channel layer 130, and the second field plate 560b having a longer length toward the drain electrode 542 than the length of the first field plate 560a may have a distance h2 (> h1) from the channel layer 130. In addition, the third field plate 560c having the longest length toward the drain electrode 541 may have a distance h3 (> h2) from the channel layer 110.

Although FIG. 11 illustrates an example in which the first to third field plates 560a, 560b, and 560c are provided above the gate electrode 130, the present disclosure is not limited thereto, and the number of field plates may be changed variously.

Each of high-k dielectric layers 570a, 570b, and 570c may be provided on a lower surface and a side surface of respectively each of the first to third field plates 560a, 560b, and 560c. FIG. 11 illustrates an example in which the high-k dielectric layers 570a, 570b, and 570c are respectively provided on the lower surfaces and the side surfaces of the first to third field plates 560a, 560b, and 560c. However, the present disclosure is not limited thereto, and the high-k dielectric layers 570a, 570b, and 570c may be respectively provided only on either the lower surfaces or the side surfaces of the first to third field plates 560a, 560b, and 560c. In addition, FIG. 11 illustrates a case in which the high-k dielectric layers 570a, 570b, and 570c are respectively provided on all the first to third field plates 560a, 560b, and 560c, but the present disclosure is not limited thereto, and the high-k dielectric layers 570a, 570b, and 570c may be provided respectively on some of the first to third field plates 560a, 560b, and 560c.

A low-k dielectric layer 550 may be provided between the first to third field plates 560a, 560b, and 560c and the barrier layer 120. The low-k dielectric layer 550 may cover the gate electrode 130 and the drain electrode 542 and may fill spaces between the first to third field plates 560a, 560b, and 560c.

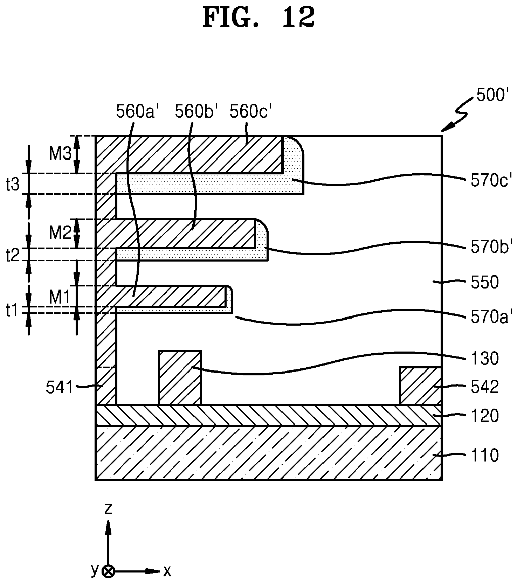

FIG. 12 is a cross-sectional view illustrating a power device 500' according to another example embodiment.

Referring FIG. 12, first to third field plates 560a', 560b', and 560c' may be provided above the gate electrode 130. The first to third field plates 560a', 560b', and 560c' may increase in thickness as a distance from the channel layer 110 increases. For example, when the first to third field plates 560a', 560b', and 560c' are sequentially provided from the channel layer 110, the first field plate 560a' may have a thickness M1, the second field plate 560b' may have a thickness M2 (> M1), and the third field plate 560c' may have a thickness M3 (> M2).

First, second, and third high-k dielectric layers 570a', 570b', and 570c' respectively provided on the first to third field plates 560a', 560b', and 560c' may increase in thickness as the distance from the channel layer 110 increases. For example, in a case in which the first to third field plates 560a', 560b', and 560c' are sequentially provided as a distance from the channel layer 110 increases, the first high-k dielectric layer 570a' provided on the first field plate 560a' may have a thickness t1, the second high-k dielectric layer 570b' provided on the second field plate 560b' may have a thickness t2 (> t1), and the third high-k dielectric layer 570c' provided on the third field plate 560c' may have a thickness t3 (> t2).

**As** such, the first to third field plates 560a', 560b', and 560c' and the first, second, and third high-k dielectric layers 570a', 570b', 570c' may increase in thickness as the distance from the channel layer 110 increases, and thus, an electric field formed at an edge portion of the gate electrode 130 may more effectively disperse.

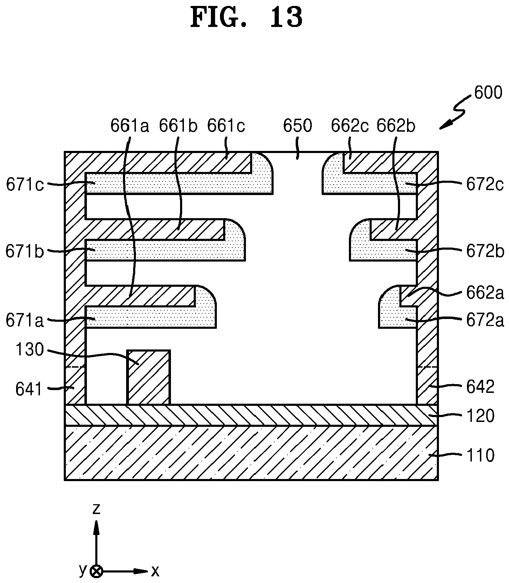

FIG. 13 is a cross-sectional view illustrating a power device 600 according to another example embodiment. Hereinafter, differences from the embodiments described above will be mainly described.

Referring to FIG. 13, the barrier layer 120 may be provided on the channel layer 110, and the gate electrode 130 may be provided on the barrier layer 120. In addition, a source electrode 641 and a drain electrode 642 may be provided on both sides of the barrier layer 120.

A plurality of first field plates 661a, 661b, and 661c may be provided above the gate electrode 130. Here, each of the first field plates 661a, 661b, and 661c may extend toward the drain electrode 642 (in the x-axis direction). The first field plates 661a, 661b, and 661c may be provided integrally with the source electrode 641. As the first field plates 661a, 661b, and 661c increase in length toward the drain electrode 642 (the x-axis direction), the distance from the channel layer 130 in a vertical direction (the z-axis direction) may increase.

First high-k dielectric layers 671a, 671b, and 671c may be respectively provided on the first field plates 661a, 661b, and 661c. Here, each of the first high-k dielectric layers 671a, 671b, and 671c may be respectively provided on at least one of a lower surface and a side surface of each of the first field plates 661a, 661b, and 661c. In addition, the first high-k dielectric layers 671a, 671b, and 671c may be respectively provided only on some of the first field plates 661a, 661b, and 661c.

A plurality of second field plates 662a, 662b, and 662c may be provided on the drain electrode 642. Here, the plurality of second field plates 662a, 662b, and 662c may extend toward the gate electrode 130 (in the -x-axis direction). The plurality of second field plates 662a, 662b, and 662c may be provided integrally with the drain electrode 642. As the plurality of second field plates 662a, 662b, and 662c increase in length toward the gate electrode 130 (-x-axis direction), distances from the channel layer 130 in the vertical direction (the z-axis direction) may increase.

Second high-k dielectric layers 672a, 672b, and 672c may be respectively provided on the plurality of second field plates 662a, 662b, and 662c. Here, each of the second high-k dielectric layers 672a, 672b, and 672c may be respectively provided on at least one of a lower surface and a side surface of each of the second field plates 662a, 662b, and 662c. In addition, the second high-k dielectric layers 672a, 672b, and 672c may be respectively provided only on some of the second field plates 662a, 662b, and 662c.

A low-k dielectric layer 650 may be provided between the first and second field plates 661a, 661b, and 661c and 662a, 662b, and 662c and the barrier layer 120. The low-k dielectric layer 650 may fill spaces between the first field plates 661a, 661b, and 661c and spaces between the second field plates 662a, 662b, and 662c.

According to the example embodiments described above, an electric field applied to an edge portion of a gate electrode may be dispersed by providing a field plate extending toward a drain electrode on an upper portion of the gate electrode. In addition, an electric field applied to an edge portion of a gate electrode may be dispersed more effectively by providing a high-k dielectric layer on at least one of a lower surface and a side surface of a field plate. Accordingly, a breakdown voltage may increase and a leakage current may reduce to implement a power device with improved high voltage characteristics and reliability.

Power devices according to example embodiments may be applied to various electronic systems and/or devices.

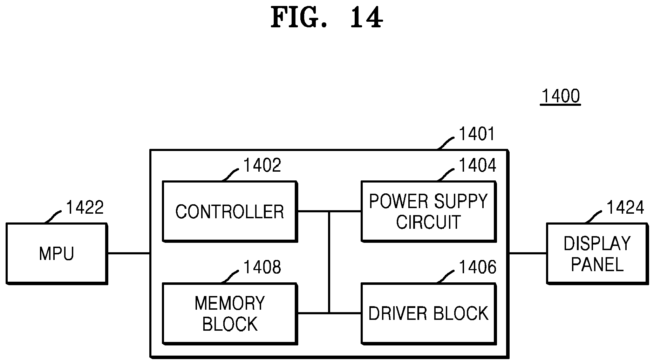

**As** an example, FIG. 14 illustrates a block diagram of an electronic system including a power device according to an example embodiment.

Referring to FIG. 14, the electronic system 1400 may include an integrated circuit (IC) 1401, such as a display-driver integrated circuit (DDI), and the IC may include a controller 1402, a power supply circuit 1404, a driver block 1406, and a memory block 1408. The controller 1402 receives and decodes a command applied from a main processor (MPU) 1422, and controls each block of the IC 1401 to implement an operation according to the command. The power supply circuit 1404 generates a driving voltage in response to the control of the controller 1402. The driver block 1406 drives a display apparatus 1424 using the driving voltage generated by the power supply circuit unit 1404 in response to the control of the controller 1402. The display apparatus 1424 may be a LED display, LCD display, or plasma display, but is not limited thereto. The memory block 1408 is a block for temporarily storing commands input to the controller 1402 or control signals output from the controller 1402 or for storing necessary data, and may include a memory (e.g., DRAM, Flash Memory. The power supply circuit 1404 and/or display panel 1424 may include a power device according to any one of the example embodiments described herein, such as any one of the power devices 100, 200, 300, 400, 500, 500', and 600 in FIGS. 1-3, 5, 7, 9, 11, 12, and 13 of the present application.

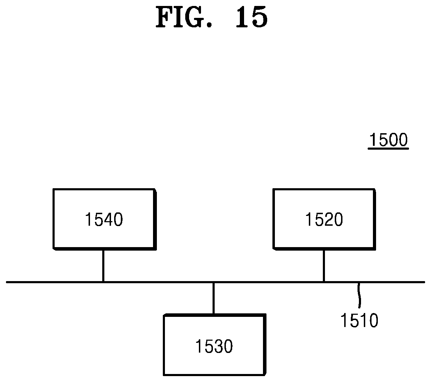

**As** another example, FIG. 15 is a block diagram of an electronic device including a power device according to an example embodiment.

**As** shown in FIG. 15, the electronic device 1500 includes one or more electronic device components, including a processor (e.g., processing circuitry) 1520 and a memory 1530 that are communicatively coupled together via a bus 1510.

**The** processing circuitry 1520 may include, and/or may be implemented by, one or more instances of processing circuitry such as hardware including logic circuits, a hardware/software combination such as a processor executing software; or a combination thereof.

In some example embodiments, the electronic device 1500 may include one or more additional components (not shown) coupled to the bus 1510, which may include, for example, a power supply, a light sensor, a light-emitting device, any combination thereof, or the like. In some example embodiments, one or more of the processing circuitry 1520, memory 1530, or one or more additional components may include a power device according to any one of the example embodiments described herein, such as any one of the power devices 100, 200, 300, 400, 500, 500', and 600 in FIGS. 1-3, 5, 7, 9, 11, 12, and 13 of the present application.

**One** or more of the elements disclosed above may include or be implemented in processing circuitry such as hardware including logic circuits; a hardware/software combination such as a processor executing software; or a combination thereof. For example, the processing circuitry may include, but is not limited to, a central processing unit (CPU) , an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims. **The following is a list of further preferred embodiments of the invention:**
Embodiment 1. A power device comprising:
   a channel layer;
   a source electrode and a drain electrode on both sides of the channel layer, respectively;
   a gate electrode over the channel layer between the source electrode and the drain electrode;
   a first field plate above the gate electrode and extending in a direction from the gate electrode toward the drain electrode, the first field plate including a metal; and
   a high-k dielectric layer on a lower surface of the first field plate, a side surface of the first field plate, or both the lower surface of the first field plate and the side surface of the first field plate.
Embodiment 2. The power device of embodiment 1, wherein the first field plate contacts the source electrode and is integral with the source electrode.
Embodiment 3. The power device of embodiment 1, wherein the first field plate has a thickness of about 10 nm to about 10 µm.
Embodiment 4. The power device of embodiment 1, wherein the high-k dielectric layer has a thickness of about 100 nm to about 3 µm.
Embodiment 5. The power device of embodiment 1, wherein the high-k dielectric layer includes at least one of SiON, SiN, Al₂O₃, HfO, and ZrO.
Embodiment 6. The power device of embodiment 1, wherein the high-k dielectric layer fills a space between the first field plate and the gate electrode.
Embodiment 7. The power device of embodiment 6, further comprising:
   a low-k dielectric layer covering the first field plate and the high-k dielectric layer.
Embodiment 8. The power device of embodiment 7, wherein the low-k dielectric layer includes SiO.
Embodiment 9. The power device of embodiment 1, further comprising:
   a low-k dielectric layer in a space between the first field plate and the gate electrode.
Embodiment 10. The power device of embodiment 9, wherein the low-k dielectric layer has a thickness of about 100 nm to about 3 µm.
Embodiment 11. The power device of embodiment 1, further comprising:
   a plurality of first field plates above the gate electrode, wherein
   the first field plate is one of the plurality of first field plates,
   lengths of the plurality of first field plates gradually increase in the direction from the gate electrode toward the drain electrode as a distance of the plurality of first plates increases from the channel layer.
Embodiment 12. The power device of embodiment 11, wherein the plurality of first field plates increase in thickness as the distance of the plurality of first field plates increases from the channel layer increases.
Embodiment 13. The power device of embodiment 11, further comprising:
   a plurality of high-k dielectric layers on the plurality of first field plates, wherein
   the high-k dielectric layer is one of the plurality of high-k dielectric layers, and
   thicknesses of the plurality of high-k dielectric layers increase as a distance of the plurality of high-k dielectric layers from the channel layer increases.
Embodiment 14. The power device of embodiment 1, further comprising:
   a second field plate connected to the drain electrode and extending in a direction from the drain electrode toward the gate electrode.
Embodiment 15. The power device of embodiment 1, wherein the channel layer includes a GaN-based material.
Embodiment 16. The power device of embodiment 15, further comprising:
   a barrier layer provided on the channel layer, wherein
   the barrier layer is configured to induce a 2-dimensional electron gas (2DEG) in the channel layer.
Embodiment 17. The power device of embodiment 16, wherein the barrier layer includes a nitride including at least one of Al, Ga, In, and B.
Embodiment 18. The power device of embodiment 1, wherein the gate electrode includes at least one of Ni, Pt, Pd, and Au.
Embodiment 19. The power device of embodiment 1, further comprising:
   an insulating layer between the channel layer and the gate electrode.
Embodiment 20. The power device of embodiment 19, wherein the insulating layer includes at least one of SiO, SiN, SiON, AIO, and AION.
Embodiment 21. The power device of embodiment 19, wherein the gate electrode includes at least one of Ti, Al, Ni, Pt, Pd, and Au.
Embodiment 22. The power device of embodiment 1, further comprising:
   a depletion forming layer between the channel layer and the gate electrode.
Embodiment 23. The power device of embodiment 22, wherein the depletion forming layer includes a p-type III-V-based nitride semiconductor.
Embodiment 24. The power device of embodiment 22, wherein the gate electrode includes at least one of Ti, Al, Ni, Pt, Pd, and Au.
Embodiment 25. A method of manufacturing a power device, the method comprising:
   forming a gate electrode on a channel layer;
   forming a low-k dielectric layer on the channel layer, the low-k dielectric layer covering the gate electrode;
   forming a first high-k dielectric layer on an upper surface of the low-k dielectric layer;
   forming a metal layer on a side surface of the first high-k dielectric layer, a side surface of the low-k dielectric layer, and an upper surface of the first high-k dielectric layer; and
   forming a source electrode on a side of the channel layer,
   the forming the source electrode including etching a portion of the metal layer and a portion of the first high-k dielectric layer, and at a same time forming a field plate on the upper surface of the first high-k dielectric layer.
Embodiment 26. The method of embodiment 25, wherein the low-k dielectric layer includes SiO.
Embodiment 27. The method of embodiment 25, wherein the first high-k dielectric layer includes at least one of SiON, SiN, Al₂O₃, HfO, and ZrO.
Embodiment 28. The method of embodiment 25, wherein
   in the forming the source electrode, the metal layer and the first high-k dielectric layer are etched by a single photo process.
Embodiment 29. The method of embodiment 25, wherein
   in the forming the source electrode, the field plate is formed above the gate electrode and formed to extend in a direction from the gate electrode toward a drain electrode, and the first high-k dielectric layer is formed on a lower surface of the field plate.
Embodiment 30. The method of embodiment 25, further comprising:
   forming a second high-k dielectric layer covering the field plate and the low-k dielectric layer; and
   etching the second high-k dielectric layer such that the second high-k dielectric layer remains only on a side surface of the field plate.
Embodiment 31. The method of embodiment 30, wherein
   the second high-k dielectric layer is formed by isotropic deposition, and
   the etching the second high-k dielectric layer is performed by an anisotropic etching process.
Embodiment 32. A method of manufacturing a power device, the method comprising:
   forming a gate electrode on a channel layer;
   forming a low-k dielectric layer on the channel layer, the low-k dielectric layer covering the gate electrode;
   forming a metal layer on a side surface of the low-k dielectric layer and an upper surface of the low-k dielectric layer;
   forming a source electrode on a side of the channel layer,
   the forming the source electrode including etching a portion of the metal layer and at a same time forming a field plate on the upper surface of the low-k dielectric layer;
   forming a high-k dielectric layer covering the field plate and the low-k dielectric layer; and
   etching the high-k dielectric layer such that the high-k dielectric layer remains only on a side surface of the field plate.
Embodiment 33. A method of manufacturing a power device, the method comprising:
   forming a gate electrode on a channel layer;
   forming a high-k dielectric layer on the channel layer, the high-k dielectric layer covering the gate electrode;
   forming a metal layer on a side surface of the high-k dielectric layer and an upper surface of the high-k dielectric layer;
   forming a source electrode on a side of the channel layer,
   the forming the source electrode including etching a portion of the metal layer and a portion the high-k dielectric layer, and at a same time forming a field plate on the upper surface of the high-k dielectric layer; and
   forming a low-k dielectric layer covering the field plate and the high-k dielectric layer.
Embodiment 34. A power device comprising:
   a channel layer;
   a source electrode, a gate electrode, and a drain electrode spaced apart from each other in a first direction on the channel layer, the gate electrode between the source electrode and the drain electrode;
   a first metal structure on the source electrode and spaced apart from the gate electrode, the first metal structure including a first field plate, the first field plate extending in the first direction over the gate electrode such that a lower surface of the first field plate faces the gate electrode, and a side surface of the first field plate over a region of the channel layer between the gate electrode and the drain electrode; and
   a high-k dielectric layer on the lower surface of the first field plate, the side surface of the first field plate, or both the lower surface of the first field plate and the side surface of the first field plate.
Embodiment 35. The power device of embodiment 34, wherein
   the first metal structure includes a vertical portion,
   the vertical portion extends from a top surface of the source electrode in a direction perpendicular to the top surface of the source electrode, and
   the first field plate extends in the first direction from a sidewall of the vertical portion.
Embodiment 36. The power device of embodiment 35, wherein
   the first metal structure includes a plurality of first field plates spaced apart from each other in the vertical direction along the vertical portion of the first metal structure,
   the plurality of first field plates include the first field plate, and the plurality of first field plates extend different lengths in the first direction.
Embodiment 37. The power device of embodiment 36, further comprising:
   a plurality high-k dielectric layers on lower surfaces of the plurality of first field plates, side surfaces of the plurality of first field plates, or both the lower surfaces of the plurality of first field plates and the side surfaces of the plurality of first field plates.
Embodiment 38. The power device of embodiment 34, further comprising:
   a second metal structure on the drain electrode, wherein
   the second metal structure is spaced apart from the gate electrode and the first metal structure,
   the second metal structure includes a second field plate, and
   the second field plate extends toward to the first metal structure in a direction opposite the first direction.

## Claims

1. A power device comprising:
a channel layer;
a source electrode and a drain electrode on both sides of the channel layer, respectively;
a gate electrode over the channel layer between the source electrode and the drain electrode;
a first field plate above the gate electrode and extending in a direction from the gate electrode toward the drain electrode, the first field plate including a metal; and
a high-k dielectric layer on a lower surface of the first field plate, a side surface of the first field plate, or both the lower surface of the first field plate and the side surface of the first field plate.

2. The power device of claim 1, wherein the first field plate contacts the source electrode and is integral with the source electrode, or
wherein the first field plate has a thickness of about 10 nm to about 10 µm.

3. The power device of claim 1 or 2, wherein the high-k dielectric layer has a thickness of about 100 nm to about 3 µm, or
wherein the high-k dielectric layer includes at least one of SiON, SiN, Al₂O₃, HfO, and ZrO, or
wherein the high-k dielectric layer fills a space between the first field plate and the gate electrode, and a low-k dielectric layer is arranged to cover the first field plate and the high-k dielectric layer, and the low-k dielectric layer including SiO.

4. The power device of one of claims 1 to 3, further comprising:
a low-k dielectric layer in a space between the first field plate and the gate electrode,
wherein the low-k dielectric layer has a thickness of about 100 nm to about 3 µm.

5. The power device of one of claims 1 to 4, further comprising:
a plurality of first field plates above the gate electrode,
wherein the first field plate is one of the plurality of first field plates,
wherein lengths of the plurality of first field plates gradually increase in the direction from the gate electrode toward the drain electrode as a distance of the plurality of first plates increases from the channel layer,
wherein the plurality of first field plates increase in thickness as the distance of the plurality of first field plates increases from the channel layer increases, or the power device further comprises a plurality of high-k dielectric layers on the plurality of first field plates, wherein the high-k dielectric layer is one of the plurality of high-k dielectric layers, and thicknesses of the plurality of high-k dielectric layers increase as a distance of the plurality of high-k dielectric layers from the channel layer increases.

6. The power device of one of claims 1 to 5, further comprising:
a second field plate connected to the drain electrode and extending in a direction from the drain electrode toward the gate electrode,
wherein the channel layer includes a GaN-based material, and the power device further comprises a barrier layer provided on the channel layer, wherein the barrier layer is configured to induce a 2-dimensional electron gas, 2DEG, in the channel layer,
wherein the barrier layer includes a nitride including at least one of Al, Ga, In, and B.

7. The power device of one of claims 1 to 6, wherein the gate electrode includes at least one of Ni, Pt, Pd, and Au, or the power device further comprises an insulating layer between the channel layer and the gate electrode,
wherein the insulating layer either includes at least one of SiO, SiN, SiON, AIO, and AION, or the gate electrode includes at least one of Ti, Al, Ni, Pt, Pd, and Au.

8. The power device of one of claim 1 to 7, further comprising a depletion forming layer between the channel layer and the gate electrode,
wherein the depletion forming layer includes a p-type III-V-based nitride semiconductor, and/or
wherein the gate electrode includes at least one of Ti, Al, Ni, Pt, Pd, and Au.

9. The power device of claim 1, wherein the source electrode, the gate electrode, and the drain electrode are spaced apart from each other in the direction on the channel layer; and
wherein the power device comprises a first metal structure on the source electrode and spaced apart from the gate electrode, the first metal structure including the first field plate, the first field plate extending in the first direction over the gate electrode such that a lower surface of the first field plate faces the gate electrode, and a side surface of the first field plate over a region of the channel layer between the gate electrode and the drain electrode.

10. The power device of claim 9, wherein
the first metal structure includes a vertical portion,
the vertical portion extends from a top surface of the source electrode in a direction perpendicular to the top surface of the source electrode, and
the first field plate extends in the first direction from a sidewall of the vertical portion,
wherein the first metal structure includes a plurality of first field plates spaced apart from each other in the vertical direction along the vertical portion of the first metal structure, the plurality of first field plates include the first field plate, and the plurality of first field plates extend different lengths in the first direction, and the power device further comprises a plurality high-k dielectric layers on lower surfaces of the plurality of first field plates, side surfaces of the plurality of first field plates, or both the lower surfaces of the plurality of first field plates and the side surfaces of the plurality of first field plates.

11. The power device of claim 9 or 10, further comprising:
a second metal structure on the drain electrode, wherein
the second metal structure is spaced apart from the gate electrode and the first metal structure,
the second metal structure includes a second field plate, and
the second field plate extends toward to the first metal structure in a direction opposite the first direction.

12. A method of manufacturing a power device, the method comprising:
forming a gate electrode on a channel layer;
forming a low-k dielectric layer on the channel layer, the low-k dielectric layer covering the gate electrode;
forming a first high-k dielectric layer on an upper surface of the low-k dielectric layer;
forming a metal layer on a side surface of the first high-k dielectric layer, a side surface of the low-k dielectric layer, and an upper surface of the first high-k dielectric layer; and
forming a source electrode on a side of the channel layer,
the forming the source electrode including etching a portion of the metal layer and a portion of the first high-k dielectric layer, and at a same time forming a field plate on the upper surface of the first high-k dielectric layer.

13. The method of claim 12, wherein
in the forming the source electrode, the metal layer and the first high-k dielectric layer are etched by a single photo process, or
in the forming the source electrode, the field plate is formed above the gate electrode and formed to extend in a direction from the gate electrode toward a drain electrode, and the first high-k dielectric layer is formed on a lower surface of the field plate, or
the method further comprises forming a second high-k dielectric layer covering the field plate and the low-k dielectric layer; and etching the second high-k dielectric layer such that the second high-k dielectric layer remains only on a side surface of the field plate, and wherein the second high-k dielectric layer is formed by isotropic deposition, and the etching the second high-k dielectric layer is performed by an anisotropic etching process.

14. A method of manufacturing a power device, the method comprising:
forming a gate electrode on a channel layer;
forming a low-k dielectric layer on the channel layer, the low-k dielectric layer covering the gate electrode;
forming a metal layer on a side surface of the low-k dielectric layer and an upper surface of the low-k dielectric layer;
forming a source electrode on a side of the channel layer, the forming the source electrode including etching a portion of the metal layer and at a same time forming a field plate on the upper surface of the low-k dielectric layer;
forming a high-k dielectric layer covering the field plate and the low-k dielectric layer; and
etching the high-k dielectric layer such that the high-k dielectric layer remains only on a side surface of the field plate.

15. A method of manufacturing a power device, the method comprising:
forming a gate electrode on a channel layer;
forming a high-k dielectric layer on the channel layer, the high-k dielectric layer covering the gate electrode;
forming a metal layer on a side surface of the high-k dielectric layer and an upper surface of the high-k dielectric layer;
forming a source electrode on a side of the channel layer,
the forming the source electrode including etching a portion of the metal layer and a portion the high-k dielectric layer, and at a same time forming a field plate on the upper surface of the high-k dielectric layer; and
forming a low-k dielectric layer covering the field plate and the high-k dielectric layer.
